# EUROPEAN PATENT SPECIFICATION

(11) **EP 2 978 295 B1**
(45) Date of publication and mention of the grant of the patent: **12.08.2020**
(21) Application number: 13879076.1
(22) Date of filing: 21.03.2013
(51) Int. Cl.: H05K 13/02, H05K 13/04

(54) **TAPE FEEDER**
BANDZUFÜHRUNG
DISPOSITIF DE DÉLIVRANCE DE BANDE

(43) Date of publication of application: 27.01.2016
(73) Proprietor: FUJI Corporation, Chiryu Aichi (JP)
(72) Inventor: KUNIHIRO Tsutomu, Chiryu Aichi (JP)
(74) Representative: Grünecker Patent- und Rechtsanwälte PartG mbB
(86) International application number: PCT/JP2013/058140
(87) International publication number: WO 2014/147799

(56) References cited:
- EP-A1- 1 381 265
- JP-A- H08 288 690
- JP-A- H10 242 686
- JP-A- H10 242 686
- JP-A- 2008 091 672
- JP-A- 2008 277 350
- JP-A- 2012 256 710
- US-A- 4 586 670
- US-A1- 2012 305 585

## Description

### Technical Field

The present invention relates to a tape feeder detachably mounted on a component mounting machine.

### Background Art

As a type of a tape feeder, a tape feeder disclosed in PTL 1 is known. As shown in FIG. 2 of PTL 1, a tape feeder 14 is detachably mounted on a component mounting machine 12, and includes a main body including a carrier tape housing electronic components, and a tape guide (tape guide member) 23, which is disposed on the upper surface of the end portion of the main body at which a component suction position where the electronic components are sucked is provided, that presses and guides the carrier tape.

### Citation List

### Patent Literature

PTL 1: JP-A-2010-109109
Further documents showing a feeder are JPH10242686 and US4586670.

### Summary of Invention

### Technical Problem

The tape feeder described in the above PTL 1 has a problem that when the carrier tape is cut by hand or the like during setup change without using a tool such as scissors, the end portion of the tape guide 23 is deformed, which causes poor suction of the electronic components, resulting in reduction in production efficiency.

The present invention is made in order to solve the above problem, and an object of the present invention is to provide a tape feeder that is capable of preventing poor suction of electronic components and thus preventing reduction in production efficiency when a carrier tape is cut by hand or the like without using a tool such as scissors.

### Solution to Problem

In order to solve the problem described above, a tape feeder according to the present invention is detachably mounted on a component mounting machine configured to mount an electronic component on a circuit board with the use of a suction nozzle, the tape feeder comprising: a main body including a carrier tape in which the electronic component is enclosed; and a tape guide disposed on an upper surface of an end portion of the main body at which a component suction position where the electronic component is sucked is provided that guides the carrier tape, wherein the tape feeder includes an end portion guide that is formed as a separate member from the main body and the tape guide and is detachably attached to the main body.

### Brief Description of Drawings

[FIG. 1] FIG. 1 is a perspective view of a component mounting machine on which a tape feeder according to the present invention is detachably mounted.
[FIG. 2] FIG. 2 is a side view showing a schematic configuration of the tape feeder shown in FIG. 1.
[FIG. 3] FIG. 3 is a perspective view of a supply reel to be mounted on the tape feeder shown in FIG. 1.
[FIG. 4] FIG. 4 is an enlarged right side view of an end portion of the tape feeder shown in FIG. 1.
[FIG. 5] FIG. 5 is an enlarged left side view of an end portion of the tape feeder shown in FIG. 1.
[FIG. 6] FIG. 6 is an enlarged perspective view of an end portion of the tape feeder shown in FIG. 1.
[FIG. 7] FIG. 7 is an enlarged right-side cross-sectional view of the end portion of the tape feeder shown in FIG. 1.
[FIG. 8] FIG. 8 is a perspective view of an end portion of the tape feeder shown in FIG. 1 that is seen from the right rear side. The tape guide is not illustrated therein.
[FIG. 9] FIG. 9 is a view mainly showing an end portion of the tape feeder and the entrance of a waste tape guide member 71 in a state where the tape feeder is mounted on the component mounting machine.
[FIG. 10] FIG. 10 is an enlarged view of an end portion of the tape feeder and the entrance of the waste tape guide member 71 shown in FIG. 9.
[FIG. 11] FIG. 11 is an enlarged perspective view of another example of an end portion guide 31d of the tape feeder shown in FIG. 1.

### Description of Embodiments

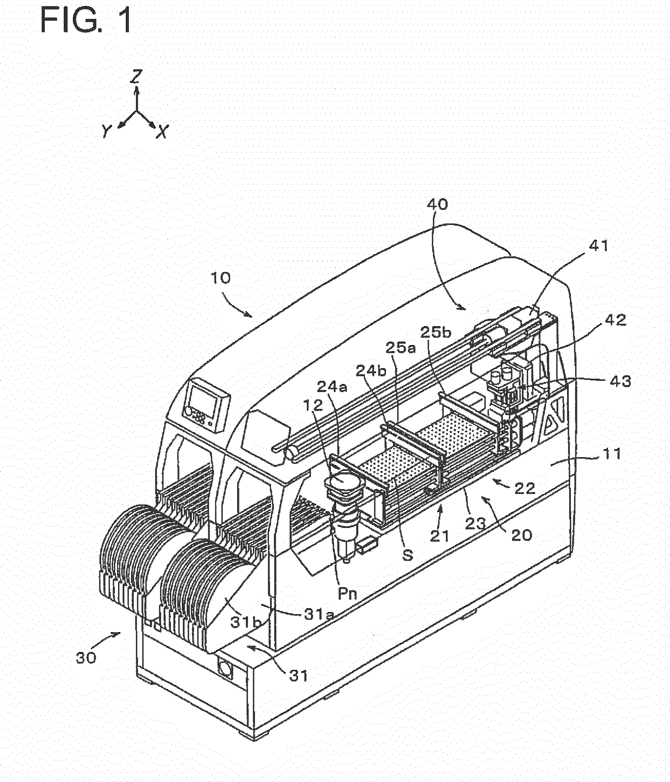

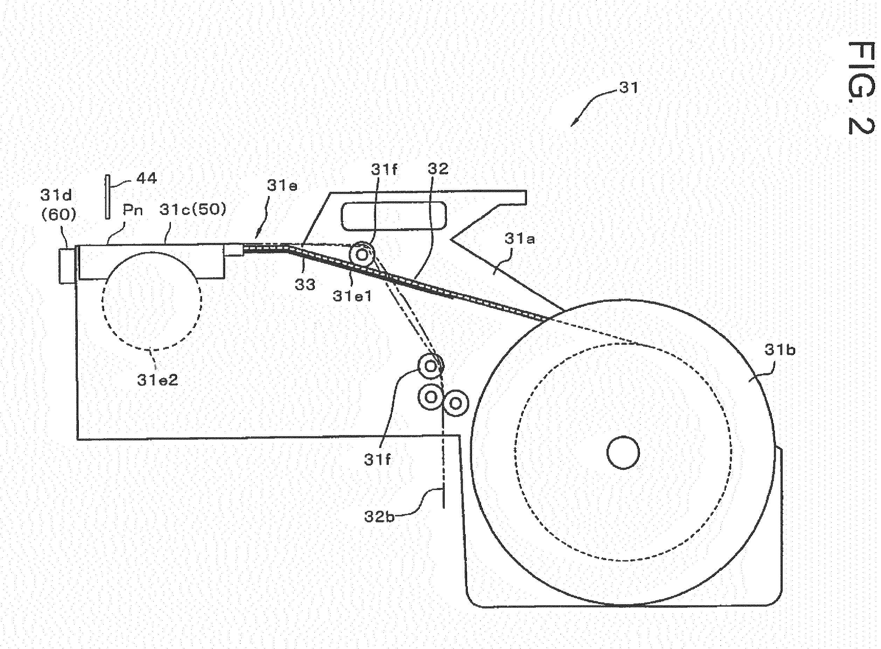

Hereinafter, an embodiment of a tape feeder according to the present invention will be described. FIG. 1 is a perspective view of a component mounting machine on which a tape feeder is detachably mounted. FIG. 2 is a side view showing a schematic configuration of the tape feeder. A component mounting machine 10 includes a board conveyance device 20, a component supply device 30, and a component transfer device 40.

As shown in FIG. 1, the board conveyance device 20 is a so-called double-conveyor-type device including a first conveyance device 21 and a second conveyance device 22 that are disposed in parallel with each other in two lines, and conveys a circuit board S in the X-axis direction. The first conveyance device 21 (second conveyance device 22) is configured such that a pair of guide rails 24a and 24b (25a and 25b) are juxtaposed horizontally to face in parallel to each other on a base 23, and a pair of conveyor belts (not illustrated) configured to support and convey the circuit board S guided by the guide rails 24a and 24b (25a and 25b) are juxtaposed to face each other.

The board conveyance device 20 includes a clamping device (not illustrated) configured to push up the circuit board S conveyed to a predetermined position and clamp the circuit board S. The circuit board S is positioned and fixed at a mounting position by the clamping device. An image capturing device 21 is provided between the board conveyance device 20 and the component supply device 30. The image capturing device 12 is for checking the suction state of electronic component 33 sucked by a suction nozzle 44 provided on a mounting head 43.

The component supply device 30 has a configuration such that a plurality of tape feeders 31 are disposed parallel with each other on a base frame 11. The tape feeders 31 are detachably mounted on the component mounting machine 10 configured to mount the electronic components 33 on the circuit board S with the use of the suction nozzle 44. As shown in FIG. 2, the tape feeders 31 include a main body 31a detachably attached to the base frame 11 (see FIG. 1), a supply reel 31b detachably mounted on the main body 31a at the rear portion, a tape guide 31c disposed at an end of the main body 31a, and an end portion guide 31d. As described above, the main body 31a of each tape feeder 31 includes a carrier tape 32 (described later) in which the electronic components 33 are enclosed.

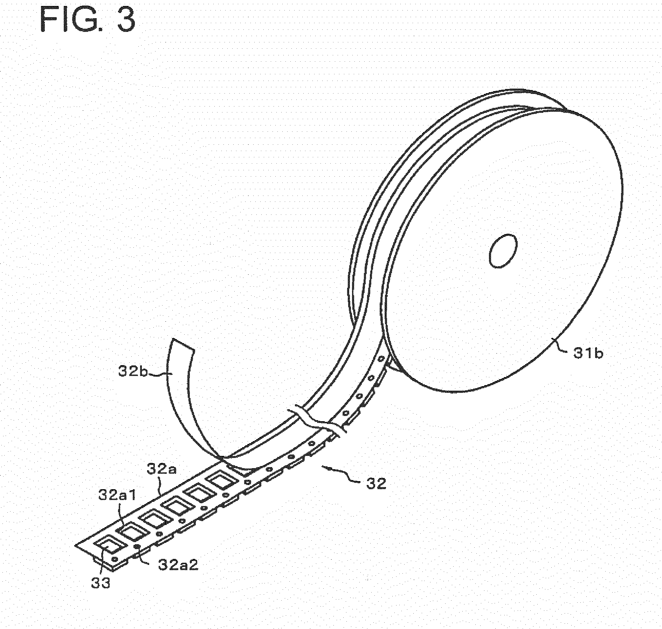

On the main body 31a of each tape feeder 31, a transfer device 31e configured to unreel by one pitch at a time the carrier tape 32 that is wound around the supply reel 31b to transfer the electronic components 33 one by one to a component suction position Pn is arranged. The transfer device 31e includes a guide portion 31el configured to guide the carrier tape 32 to the component suction position Pn, a sprocket 31e2 rotatably supported on the main body 31a to engage feed holes 32a2 of the carrier tape 32 (see FIG. 3), and a motor (not illustrated) configured to rotate the sprocket 31e2 by one pitch at a time. The main body 31a includes a plurality of rollers 31f configured to guide cover tape 32b (see FIG. 3) peeled off prior to the component suction position Pn so as to be discharged to a predetermined position.

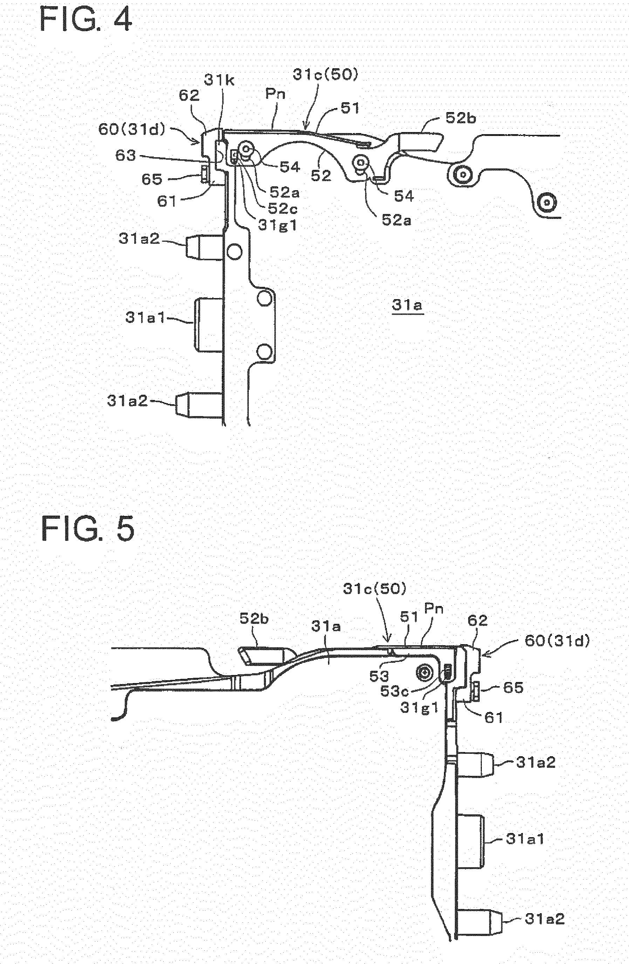

Note that a communication connector 31al and two positioning pins 31a2 are provided on an end surface of the main body 31a as shown in FIGs. 4 and 5. The communication connector 31a1 is connected with a feeder holding stand (not illustrated). The two positioning pins 31a2 are disposed apart from each other in the vertical direction, and are used for positioning with respect to the feeder holding stand, and ultimately with respect to the component mounting machine 10.

The supply reel 31b is rotatably and detachably mounted on the main body 31a of the tape feeder 31 as shown in FIG. 2. The carrier tape 32 holding a predetermined number of the electronic components 33 at regular intervals is wound around the supply reel 31b (see FIG. 3).

The carrier tape 32 includes a long thin embossed tape 32a (a carrier tape main body) made from resin and having a predetermined width, and the cover tape 32b bonded to the embossed tape 32a as shown in FIG. 3. Cavities 32a1 into which the electronic components 33 are enclosed are provided in the longitudinal direction of the embossed tape 32a at predetermined intervals while the feed holes 32a2 are provided in the embossed tape 32a at the edge portion on one end side in the width direction at the same intervals as the cavities 32al. In the present embodiment, while an embossed-carrier-type carrier tape is used as the carrier tape 32, a punch-carrier-type carrier tape in which cavities and feed holes are provided in a paper main body may be used.

The tape guide 31c (50) is disposed on an upper surface of an end portion of the main body 31a at which the component suction position Pn where the electronic components 33 are sucked is provided, and is configured to press and guide the carrier tape 32.

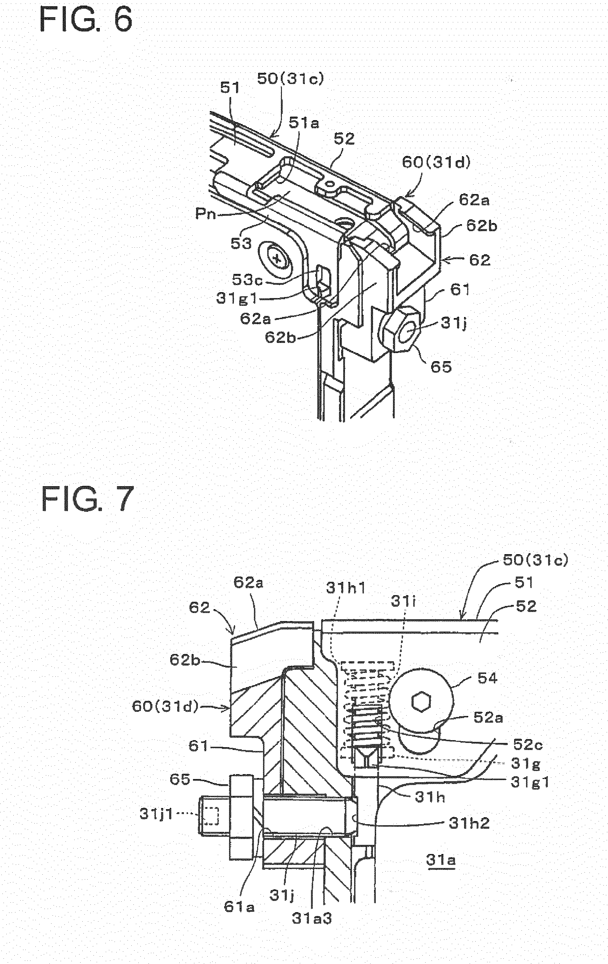

The tape guide 31c (50) mainly includes an upper plate portion 51, a first side plate portion 52, and a second side plate portion 53 as shown in FIGs. 4 to 6. The upper end of the first side plate portion 52 is connected with one side (e.g. , the right side) of the upper plate portion 51 while the upper end of the second side plate portion 53 is connected with the other side (e.g., the left side) of the upper plate portion 51. When seen from an end side in FIG. 6, the tape guide 31c basically has the shape of the letter U opening downward.

A cutout 51a is provided in an end portion of the upper plate portion 51 of the tape guide 31c so as to correspond to the component suction position Pn as shown in FIG. 6. The cutout 51a has a configuration such that the electronic component 33 housed in the carrier tape 32 can be removed with the use of the suction nozzle 44 at the component suction position Pn.

Long holes 52a elongated in the vertical direction are provided in the first side plate portion 52 at two positions in the back/forth direction as shown in FIG. 4. The first side plate portion 52 is sandwiched movable in the vertical direction between the head portions of mounting screws 54 inserted into the long holes 52a to be fastened to the main body 31a and the side surface of the main body 31a. A lever portion 52b is provided on the first side plate portion 52 at the rear end. The tape guide 31c is configured to hold the carrier tape 32 between the tape guide 31c and the sprocket 31e2 in a normal state (a state where the lever portion 52b is not lifted up), and release the tape in a state in which the lever 52b is lifted up. Thus, the tape guide 31c is held movable in the vertical direction at an end portion of the main body 31a.

Mainly, an engaging hole 52c elongated in the vertical direction is provided in the first side plate portion 52 at the front end portion (the left side in FIG. 4 is the front side) as shown in FIG. 7. An engaging pawl 31g1 of a pressing member 31g is inserted into the engaging hole 52c so as to be relatively movable in the vertical direction. The pressing member 31g is biased downward by a spring 31i interposed between the pressing member 31g and a flange portion 31h1 provided on a pin-shaped fixing member 31h at an upper end.

The fixing member 31h passes through a through-hole (not illustrated) provided in the center of the pressing member 31g. The lower end of the fixing member 31h is screwed to be fixed to the main body 31a. To be specific, a screw 31j is screwed to a screw portion 31a3 of the main body 31a, and the end of the screw 31j is in contact with a fixing flat surface 31h2 provided on the fixing member 31h at the lower end. Thus, the fixing member 31h is fixed to the main body 31a. Note that the screw 31j has no head portion, and a recessed portion 31j 1 that corresponds to a tool such as a hexagon wrench is provided on the end surface on the head portion side.

In addition, an engaging hole 53c elongated in the vertical direction is provided in the second side plate portion 53 as shown in FIG. 5 in the same manner as the first side plate portion 52. The engaging pawl 31g1 of the pressing member 31g is inserted into the engaging hole 53c so as to be relatively movable in the vertical direction.

Thus, the tape guide 31c is pressed toward the upper surface of the main body 31a by the biasing force of the spring 31i (see FIG. 7) in a state in which the engaging pawl 31g1 of the pressing member 31g is in contact with the lower ends of the engaging hole 52c and the engaging hole 53c.

The end portion guide 31d is formed as a separate member from the main body 31a and the tape guide 31c, and is detachably attached to the main body 31a.

The end portion guide 31d (60) includes mainly a main body 61 and a guide portion 62 as shown in FIGs. 6 to 8. The main body 61 is fastened with a nut 65 to the main body 31a of the tape feeder 31. To be specific, a through-hole 61a is provided in the main body 61 as shown in FIG. 7. The screw 31j screwed to be fastened to the main body 31a of the tape feeder 31 passes through the through-hole 61a. The nut 65 is screwed to the screw 31j. Thus, the end portion guide 60 is fastened and fixed by the nut 65 to the screw 31j configured to fasten the main body 31a that is a member separate from the end portion guide 60 to the fixing member 31h. Note that the screw 31j may be screwed to be fastened to any member other than the main body 31a as long as the member is different from the end portion guide 60.

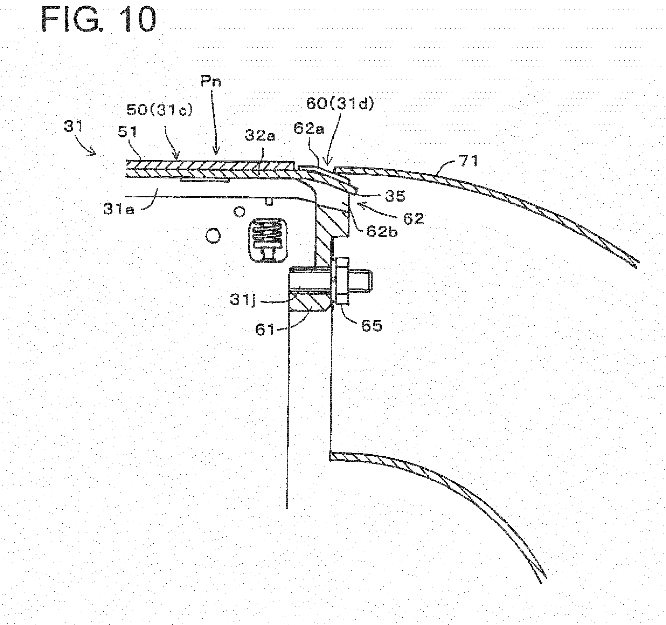

The guide portion 62 guides a waste tape 35, which is the carrier tape 32 from which the electronic components 33 have been removed at the component suction position Pn, lower than the plane of the lower surface of the tape guide 31c (see FIG. 10) . To be specific, the guide portion 62 includes mainly a pair of pawl portions 62a and 62a configured to press and guide both sides of the waste tape 35 as shown in FIGs. 6 to 8. The guide portion 62 includes the pair of pawl portions 62a and 62a and a pair of side wall portions 62b and 62b. Each side wall portion 62b is provided on the main body 61 of the end portion guide 60 at the upper portion extending upward. Both of the side wall portions 62b are formed flat, and are arranged in parallel facing each other with a distance larger than the width of the waste tape 35 therebetween.

The pawl portions 62a are respectively disposed on the upper end edge portion of the side wall portions 62b. The pawl portions 62a protrude from the upper end inner side of the side wall portions 62b toward the side wall portions 62b facing each other. Each pawl portion 62a is formed in a convex shape continuously from an introduction end from which the waste tape 35 is introduced up to an exit end from which the waste tape 35 exits. The introduction end on the lower surface of each pawl portion 62a is preferably disposed above the lower surface of the tape guide 31c. Thus, the waste tape 35 discharged from the tape guide 31c is smoothly introduced into the guide portion 62 without being caught on the introduction end of each pawl portion 62a. The introduction end on the upper surface of each pawl portion 62a is disposed below the same plane as the upper surface of the tape guide 31c. Thus, the suction nozzle 44 sucking the electronic components 33 and the guide portion 62 can be prevented from being brought into contact with each other.

The lower surface of each pawl portion 62a is formed inclined downward as shown in FIG. 7. To be specific, the lower surface of each pawl portion 62a may be formed horizontal for some length from the introduction end and inclined downward in midstream, may be formed inclined downward immediately from the introduction end, or may be formed in an arc shape not in a linear shape. The introduction end on the lower surface of each pawl portion 62a is disposed below the same plane as the lower surface of the tape guide 31c. Thus, the waste tape 35 introduced into the guide portion 62 is guided to be discharged lower than the plane of the lower surface of the tape guide 31c by the pair of pawl portions 62a and 62a.

Note that either one of the pawl portions 62a may be provided instead of being provided in pairs. In this case, the pawl portion 62a presses and guides one side of the waste tape 35. In addition, the introduction end on the lower surface of each pawl portion 62a may be disposed at the same height as the lower surface of the tape guide 31c.

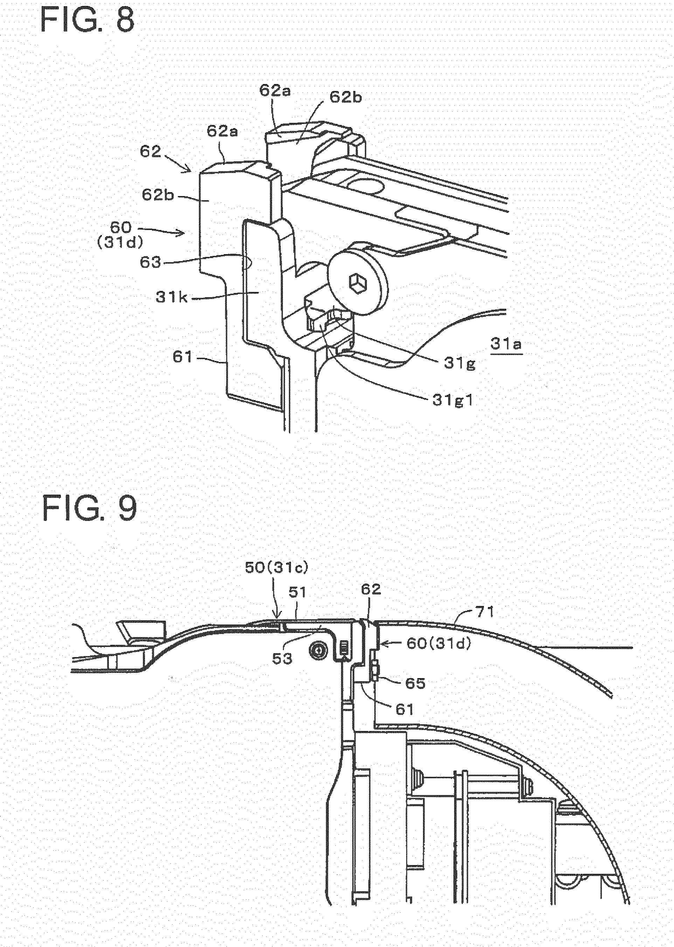

The end portion guide 31d (60) includes mainly an engaging recessed portion 63 as shown in FIG. 8. The engaging recessed portion 63 engages engaging convex portion 31k provided on the main body 31a of the tape feeder 31. Making the engaging recessed portion 63 engage the engaging convex portion 31k allows the end portion guide 31d to be positioned at an engaging position of the main body 31a.

Note that the engaging convex portion may be provided on the end portion guide 31d and the engaging recessed portion configured to engage the engaging recessed portion may be provided on the main body 31a.

The state where the tape feeder 31 in which the end portion guide 31d is attached to the main body 31a is mounted on the component mounting machine 10 will be described with reference to FIGs. 9 and 10.

The component mounting machine 10 includes a waste tape disposal unit (not illustrated) . The waste tape disposal unit is configured to collect and process the waste tape 35 discharged from the tape feeder 31. The waste tape disposal unit includes a waste tape guide member 71 configured to collect and discharge the waste tape 35 discharged from the tape feeder 31. The waste tape guide member 71 is formed in a duct shape or a tube shape.

The positioning pins 31a2 of the tape feeder 31 are positioned with respect to the component mounting machine 10, thus the tape feeder 31 is mounted on the component mounting machine 10 at a fixed position. At this time, at least the lower end of the guide portion 62, that is, the exit end of the pawl portions 62a, are disposed inside the entrance of the waste tape guide member 71. In addition, the upper portion of the opening end of the entrance of the waste tape guide member 71 is disposed below the same plane as the upper surface of the tape guide 31c. Thus, continuously passing through the guide portion 62 of the end portion guide 31d, the waste tape 35 discharged from the end of the tape guide 31c is discharged lower than the plane of the lower surface of the tape guide 31c. Then, the waste tape 35 discharged from the guide portion 62 is collected in the waste tape guide member 71.

As shown in FIG. 1, the component transfer device 40 is an XY robot-type device, is mounted on the base frame 11 and disposed above the board conveyance device 20 and the component supply device 30, and includes a Y-axis slider 42 moved in the Y-axis direction by a Y-axis motor 41. The mounting head 43 including the suction nozzle 44 configured to suck and to mount the electronic components 33 on the circuit board S is attached to the Y-axis slider 42.

According to the above-described embodiment, the end portion guide 31d (60) is formed as a separate member from the main body 31a and the tape guide 31c, and is detachably attached to the main body 31a. Thus, in case the end portion guide 31d (60) is deformed when the carrier tape 32 is cut by hand or the like during setup change without using a tool such as scissors (or the carrier tape 32 is broken during transportation of the tape feeder 31), replacing the deformed end portion guide 31d (60) with a new end portion guide 31d (60) can prevent poor suction of the electronic components, and also the time for replacement can be reduced as much as possible to prevent reduction in production efficiency.

In addition, the end portion guide 31d (60) includes the guide portion 62 configured to guide the waste tape 35, which is the carrier tape 32 from which the electronic components 33 have been removed at the component suction position Pn, lower than a plane the same as the lower surface of the tape guide 31c. With this configuration, even when the carrier tape 32 is cut by hand or the like during setup change without using a tool such as scissors, the waste tape 35 discharged from the end of the tape guide 31c continuously passes through the guide portion 62 of the end portion guide 31d, so that the waste tape 35 is discharged lower than the plane of the lower surface of the tape guide 31c. Consequently, the waste tape 35 discharged from the end of the tape guide 31c is disposed below the same plane as the lower surface of the tape guide 31c. Thus, the suction nozzle 44 sucking the electronic components 33 is not brought into contact with the waste tape 35 discharged from the end of the end portion guide 31d, which can prevent faulty mounting of the electronic components 33.

In addition, the component mounting machine 10 further includes the waste tape guide member 71 configured to collect and discharge the waste tape 35. When the tape feeder 31 is mounted on the component mounting machine 10, at least the lower end of the guide portion 62 (pawl portion 62a) is disposed inside the entrance of the waste tape guide member 71, and the upper portion of the opening end of the entrance of the waste tape guide member 71 is disposed below the same plane as the upper surface of the tape guide 31c (50). With this configuration, the waste tape 35 discharged from the end portion guide 31d (60) is reliably collected into the waste tape guide member 71 where the lower end of the guide portion 62 is disposed inside the entrance. Thus, the suction nozzle 44 sucking the electronic components 33 can be reliably prevented from being brought into contact with the waste tape 35 discharged from the end of the end portion guide 31d. In addition, the waste tape guide member 71 is disposed below the same plane as the upper surface of the tape guide 31c (50) . Thus, the suction nozzle 44 sucking the electronic components 33 can be reliably prevented from being brought into contact with the waste tape guide member 71.

In addition, the upper end of the guide portion 62 of the end portion guide 31d (60) is disposed below the same plane as the upper surface of the tape guide 31c (50). Thus, the suction nozzle 44 sucking the electronic components 33 can be reliably prevented from being brought into contact with the guide portion 62 of the end portion guide 31d.

In addition, the end portion guide 31d (60) includes the engaging recessed portions 63 while the main body 31a includes the engaging convex portions 31k configured to engage with the engaging recessed portions 63. Making the engaging recessed portions 63 engage with the engaging convex portions 31k allows the end portion guide 31d to be positioned at the engaging position of the main body 31a. Thus, the end portion guide 31d can be reliably positioned at the engaging position (a position in the vertical direction) of the main body 31a with a simple configuration. Consequently, errors in attachment are reduced, and thereby the suction nozzle 44 sucking the electronic components 33 can be reliably prevented from being brought into contact with the guide portion 62 of the end portion guide 31d and the waste tape 35.

In addition, the end portion guide 31d (60) is fastened and fixed with the nut 65 to the screw 31j configured to fasten the fixing member 31h that is a member separate from the end portion guide 31d to the main body 31a. Thus, the number of components can be reduced and the structure can be simplified.

In addition, the guide portion 62 of the end portion guide 31d (60) includes the pair of pawl portions 62a and 62a configured to press and guide both the sides of the waste tape 35 (or the pawl portion 62a configured to press and guide one side of the waste tape 35). Thus, when the waste tape 35 is stuck in the guide portion 62, the stuck waste tape 35 can be easily removed.

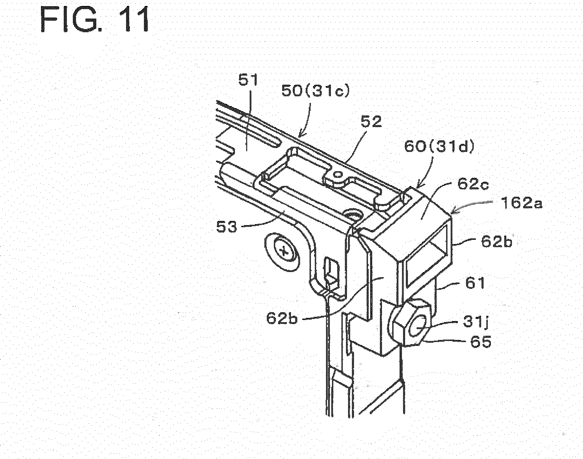

Note that in the configuration of the above-described embodiment the guide portion 62 of the end portion guide 31d (60) includes the pair of pawl portions 62a and 62a configured to press and guide both the sides of the waste tape 35 (or the pawl portion 62a configured to press and guide one side of the waste tape 35), but instead the configuration may be such that the guide portion 62 of the end portion guide 31d (60) includes a pressing portion having an arch shape. To be specific, a guide portion 162 of the end portion guide 31d (60) includes a pressing portion 162a having an arch shape and configured to press and guide the waste tape 35 across the width direction of the waste tape 35 as shown in FIG. 11. The pressing portion 162a includes the above-described pair of side wall portions 62b and 62b, and an upper wall portion 62c connecting the upper end edges of both the side wall portions 62b. Thus, the stiffness of the end portion guide 31d can be improved, so that even when the carrier tape 32 is cut by hand or the like without using a tool such as scissors, the end portion guide 31d can be prevented from being easily deformed. In addition, the waste tape is reliably guided by the pressing portion 162a to be reliably discharged lower than the plane of the lower surface of the tape guide.

### Reference Signs List

10...Component mounting machine, 11...Base frame, 12...Image capturing device, 20...Board conveyance device, 30...Component supply device, 31...Tape feeder, 31a...Main body, 31al... Communication connector, 31a2... Positioning pins, 31a3...Screw portion, 31b...Supply reel, 31c...Tape guide, 31d...End portion guide, 31e...Transfer device, 31el...Guide portion, 31e2...Sprocket, 31f...Rollers, 31g...Pressing member, 31g1...Engaging pawl, 31h...Fixing member, 31h1...Flange portion, 31h2...Fixing flat surface, 31i... Spring, 31j...Screw, 31j1...Recessed portions, 31k...Engaging convex portions, 32...Carrier tape, 32a...Embossed tape, 32al... Cavities, 32a2...Feed holes, 32b...Cover tape, 33...Electronic components, 35... Waste tape, 40...Component transfer device, 41...Y-axis motor, 42...Y-axis slider, 43...Mounting head, 44...Suction nozzle, 50...Tape guide, 51...Upper plate portion, 51a...Cutout, 52 and 53 ... First and second side plate portions, 52a... Long holes, 52b...Lever portion, 52c and 53c...Engaging holes, 54...Mounting screws, 60...End portion guide, 61... Main body, 61a...Through-hole, 62 and 162...Guide portions, 62a...Pawl portions, 62b...Sidewall portions, 65...Nut, 71...Waste tape guide member, Pn...Component suction position, S...Circuit board

## Claims

1. A tape feeder (31) detachably mounted on a component mounting machine (10) configured to mount an electronic component (33) on a circuit board (S) with the use of a suction nozzle (44), the tape feeder (31) comprising:
a main body (31a) including a carrier tape (32) in which the electronic component (33) is enclosed; and a tape guide (31c, 50) that is disposed on an upper surface of an end portion of the main body (31a) at which a component suction position (Pn) where the electronic component (33) is sucked is provided, and guides the carrier tape (32),
wherein the tape feeder (31) includes an end portion guide (31d, 60) that is formed as a separate member from the main body (31a) and the tape guide (31c, 50) and is detachably attached to the main body (31a) by a nut (65) to fasten and fix the end portion guide (31c, 50) to a screw (31j) configured to fasten a member that is separate from the end portion guide (31c, 50) to the main body (31a),
wherein the end portion guide (31d, 60) comprises a guide portion (62) configured to guide waste tape (35), which is the carrier tape (32) from which the electronic components (33) have been removed at the component suction position (Pn), lower than the plane of the lower surface of the tape guide (31c, 50).

2. The tape feeder according to claim 1,
wherein the component mounting machine (10) further comprises a waste tape guide member (71) configured to collect and discharge the waste tape (35),
wherein when the tape feeder (31) is mounted on the component mounting machine (10), at least a lower end of the guide portion (62) is disposed inside an entrance of the waste tape guide member (71), and
wherein an upper portion of an opening end of the entrance of the waste tape guide member (71) is disposed below the same plane as the upper surface of the tape guide (31c, 50).

3. The tape feeder according to any one of claims 1 to 2, wherein an upper end of the guide portion (62) is disposed below the same plane as the upper surface of the tape guide (31c, 50).

4. The tape feeder according to any one of claims 1 to 3, wherein the end portion guide (31d, 60) comprises one of an engaging convex portion and an engaging recessed portion (63), and the main body (31a) comprises one of an engaging recessed portion and an engaging convex portion (31k) that engages with the engaging convex portion or the engaging recessed portion (63), and wherein by making the engaging convex portion (31k) engage with the engaging recessed portion (63), the end portion guide (31 d, 60) is positioned at an engaging position of the main body (31a).

5. The tape feeder according to any one of claims 1 to 4 wherein the guide portion (62) of the end portion guide (31d, 60) comprises one of a pawl portion (62a) configured to press and guide one side of the waste tape (35), and a pair of pawl portions (62a) configured to press and guide both sides of the waste tape (35).

6. The tape feeder according to any one of claims 1 to 4, wherein the guide portion (62) of the end portion guide (31d, 60) is configured to include a pressing portion formed in an arch shape so as to guide the waste tape (35) while pressing the waste tape (35) over a width direction of the waste tape (35).

## Patentansprüche

1. Band-Zuführvorrichtung (31), die abnehmbar an einer Maschine (10) zum Montieren von Bauteilen angebracht ist, die so eingerichtet ist, dass sie ein elektronisches Bauteil (33) unter Verwendung einer Saugdüse (44) an einer Leiterplatte (S) montiert, wobei die Band-Zuführvorrichtung (31) umfasst:
einen Hauptkörper (31a), der ein Trägerband (32), in dem das elektronische Bauteil (33) eingeschlossen ist; und eine Bandführung (31c, 50) enthält, die an einer oberen Fläche eines Endabschnitts des Hauptkörpers (31a) angeordnet ist, an der eine Bauteil-Ansaugposition (Pn) vorhanden ist, an der das elektronische Bauteil (33) angesaugt wird, und die das Trägerband (32) führt,
wobei die Band-Zuführvorrichtung (31) eine Endabschnitt-Führung (31d, 60) enthält, die als ein von dem Hauptkörper (31a) und der Bandführung (31c, 50) getrenntes Element ausgebildet ist und an dem Hauptkörper (31a) mittels einer Mutter (65) zum Befestigen und Fixieren der Endabschnitt-Führung (31c, 50) an einer Schraube (31j) lösbar angebracht ist, die zum Befestigen eines Elementes, das von der Endabschnitt-Führung (31c, 50) getrennt ist, an dem Hauptkörper (31a) eingerichtet ist,
wobei die Endabschnitt-Führung (31d, 60) einen Führungsabschnitt (62) umfasst, der so eingerichtet ist, dass er gebrauchtes Band (35), bei dem es sich um Trägerband (32) handelt, aus dem die elektronischen Bauteile (33) an der Bauteil-Ansaugposition (Pn) entfernt worden sind, weiter nach unten als zu der Ebene der unteren Fläche der Bandführung (31c, 50) führt.

2. Band-Zuführvorrichtung nach Anspruch 1,
wobei die Maschine (10) zum Montieren von Bauteilen des Weiteren ein Führungselement (71) für gebrauchtes Band umfasst, das so eingerichtet ist, dass es das gebrauchte Band (35) sammelt und ableitet,
wobei, wenn die Band-Zuführvorrichtung (31) an der Maschine (10) zum Montieren von Bauteilen angebracht ist, wenigstens ein unteres Ende des Führungsabschnitts (62) innerhalb eines Eingangs des Führungselementes (71) für gebrauchtes Band angeordnet ist, und
ein oberer Abschnitt eines Öffnungsendes des Eingangs des Führungselementes (71) für gebrauchtes Band unterhalb der gleichen Ebene wie der oberen Fläche der Bandführung (31c, 50) angeordnet ist.

3. Band-Zuführvorrichtung nach einem der Ansprüche 1 bis 2, wobei ein oberes Ende des Führungsabschnitts (62) unterhalb der gleichen Ebene wie der oberen Fläche der Bandführung (31c, 50) angeordnet ist.

4. Band-Zuführvorrichtung nach einem der Ansprüche 1 bis 3, wobei die Endabschnitt-Führung (31d, 60) einen konvexen Eingriffsabschnitt oder einen vertieften Eingriffsabschnitt (63) umfasst und der Hauptkörper (31a) einen vertieften Eingriffsabschnitt oder einen konvexen Eingriffsabschnitt (31k) umfasst, der mit dem konvexen Eingriffsabschnitt oder dem vertieften Eingriffsabschnitt (63) in Eingriff ist, und wobei dadurch, dass der konvexe Eingriffsabschnitt (31k) mit dem vertieften Eingriffsabschnitt (63) in Eingriff gebracht wird, die Endabschnitt-Führung (31d, 60) in einer Eingriffsposition des Hauptkörpers (31a) positioniert wird.

5. Band-Zuführvorrichtung nach einem der Ansprüche 1 bis 4, wobei der Führungsabschnitt (62) der Endabschnitt-Führung (31d, 60) einen Klinkenabschnitt (62a), der so eingerichtet ist, dass er eine Seite des gebrauchten Bandes (35) drückt und führt, oder ein Paar - Klinkenabschnitte (62a) umfasst, die so eingerichtet sind, dass sie beide Seiten des gebrauchten Bandes (35) drücken und führen.

6. Band-Zuführvorrichtung nach einem der Ansprüche 1 bis 4, wobei der Führungsabschnitt (62) der Endabschnitt-Führung (31d, 60) so eingerichtet ist, dass er einen in einer Bogenform ausgebildeten Drück-Abschnitt aufweist, der das gebrauchte Band (35) führt und dabei gleichzeitig das gebrauchte Band (35) über eine Breitenrichtung des gebrauchten Bandes (35) drückt.

## Revendications

1. Dispositif d'alimentation en bande (31) monté amovible sur une machine de montage de composants (10) configurée pour monter un composant électronique (33) sur une carte à circuit imprimé (S) grâce à l'utilisation d'une buse d'aspiration (44), le dispositif d'alimentation en bande (31) comprenant :
un corps principal (31a) incluant une bande porteuse (32) sur laquelle est intégré le composant électronique (33), ainsi qu'un guide de bande (31c, 50) qui est disposé sur la surface supérieure d'une partie terminale du corps principal (31a) au niveau de laquelle est prévue une position d'aspiration de composant (Pn) où est aspiré le composant électronique (33), et qui guide la bande porteuse (32),
où le dispositif d'alimentation en bande (31) inclut un guide de partie terminale (31d, 60) qui est formé comme élément séparé du corps principal (31a) et du guide de bande (31c, 50) et qui est fixé tout en étant amovible au corps principal (31a) grâce à un écrou (65) dans le but d'assembler et fixer le guide de partie terminale (31c, 50) à une vis (31j) configurée pour assembler un élément, qui est séparé du guide de partie terminale (31c, 50), au corps principal (31a) ,
dans lequel le guide de partie terminale (31d, 60) comprend un organe de guidage (62) configuré pour guider une bande rebut (35) qui est la bande porteuse (32) de laquelle ont été enlevés les composants électroniques (33) au niveau de la position d'aspiration de composants (Pn), au niveau inférieur au plan de la surface inférieure du guide de bande (31c, 50).

2. Dispositif d'alimentation en bande selon la revendication 1,
où la machine de montage de composants (10) comprend un élément de guidage de bande rebut (71) configuré pour recueillir et éjecter la bande rebut (35),
où, lorsque le dispositif d'alimentation en bande (31) est monté sur la machine de montage de composants (10), au moins l'extrémité inférieure de l'organe de guidage (62) est disposée à l'intérieur d'une entrée de l'élément de guidage de bande rebut (71), et
où la partie supérieure de l'extrémité ouvrante de l'entrée de l'élément de guidage de bande rebut (71) est disposée en dessous du même plan que la surface supérieure du guide de bande (31c, 50).

3. Dispositif d'alimentation en bande selon l'une quelconque des revendications 1 et 2, dans lequel l'extrémité supérieure de l'organe de guidage (62) est disposée en dessous du même plan que la surface supérieure du guide de bande (31c, 50).

4. Dispositif d'alimentation en bande selon l'une quelconque des revendications 1 à 3, dans lequel le guide de partie terminale (31d, 60) comprend l'un d'un organe convexe de mise en prise et d'un organe en creux de mise en prise (63), et le corps principal (31a) comprend l'un d'un organe en creux de mise en prise et d'un organe convexe de mise en prise (31k) qui s'engrène avec l'organe convexe de mise en prise ou l'organe en creux de mise en prise (63), et où, en faisant s'engrener l'organe convexe de mise en prise (31k) avec l'organe en creux de mise en prise (63), le guide de partie terminale (31d, 60) est positionnée sur une position d'engrènement du corps principal (31a).

5. Dispositif d'alimentation en bande selon l'une quelconque des revendications 1 à 4, dans lequel l'organe de guidage (62) du guide de partie terminale (31d, 60) comprend l'un d'un organe formant cliquet (62a) configuré pour presser et pour guider un côté de la bande rebut (35), ainsi qu'une paire d'organes formant cliquet (62a) configurés pour presser et pour guider les deux côtés de la bande rebut (35).

6. Dispositif d'alimentation en bande selon l'une quelconque des revendications 1 à 4, dans lequel l'organe de guidage (62) du guide de partie terminale (31d, 60) est configuré pour inclure un organe de pressage façonné comme un arc de sorte à guider la bande rebut (35) tout en pressant la bande rebut (35) sur la direction de la largeur de la bande rebut (35).
